(19) Europäisches Patentamt / European Patent Office / Office européen des brevets

(11) **EP 1 362 361 B1**

(12) **EUROPÄISCHE PATENTSCHRIFT**

(45) Veröffentlichungstag und Bekanntmachung des Hinweises auf die Patenterteilung:
**23.04.2008 Patentblatt 2008/17**

(21) Anmeldenummer: **02722075.5**

(22) Anmeldetag: **14.02.2002**

(51) Int Cl.:
*H01J 37/05* (2006.01)    *H01J 37/28* (2006.01)
*H01J 37/153* (2006.01)

(86) Internationale Anmeldenummer:
**PCT/EP2002/001553**

(87) Internationale Veröffentlichungsnummer:
**WO 2002/067286 (29.08.2002 Gazette 2002/35)**

(54) **TEILCHENSTRAHLSYSTEM MIT EINEM SPIEGELKORREKTOR**

PARTICLE BEAM SYSTEM COMPRISING A MIRROR CORRECTOR

SYSTEME DE FAISCEAU DE PARTICULES A CORRECTEUR SPECULAIRE

(84) Benannte Vertragsstaaten:
**DE GB NL**

(30) Priorität: **20.02.2001 DE 10107910**

(43) Veröffentlichungstag der Anmeldung:
**19.11.2003 Patentblatt 2003/47**

(73) Patentinhaber: **Carl Zeiss NTS GmbH
73447 Oberkochen (DE)**

(72) Erfinder:
• **ROSE, Harald
64287 Darmstadt (DE)**
• **PREIKSZAS, Dirk
63743 Aschaffenburg (DE)**
• **HARTEL, Peter
64289 Darmstadt (DE)**

(74) Vertreter: **Gnatzig, Klaus
Carl Zeiss
Patentabteilung
73446 Oberkochen (DE)**

(56) Entgegenhaltungen:
**EP-A- 0 530 640**

• **ROSE H ET AL: "Time-dependent perturbation formalism for calculating the aberrations of systems with large ray gradients" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, Bd. A363, Nr. 1, 1995, Seiten 301-315, XP004009661 ISSN: 0168-9002**

**Beschreibung**

Die Erfindung betrifft ein Teilchenstrahlsystem mit einem Spiegelkorrektor. Ein derartiges System ist beispielsweise aus der EP-B1 0530640 bekannt. Der Spiegelkorrektor dient bei solchen Systemen zur Korrektur der geometrischen und energieabhängigen Abbildungsfehler der im System enthaltenen teilchenoptischen Komponenten.

Spiegelkorrektoren weisen neben einem elektrostatischen Spiegel einen magnetischen Strahlumlenker auf. Ein solcher Strahlumlenker dient dabei gewissermaßen als Weiche für die Teilchenstrahlen, um einerseits den von einer Quelle austretenden Teilchenstrahl zu dem elektrostatischen Spiegel und den am elektrostatischen Spiegel reflektierten Teilchenstrahl zu der nachfolgenden Abbildungsoptik zu lenken.

Damit der Strahlumlenker als nicht-rotationssymmetrisches Bauteil nicht selbst Fehler zweiter Ordnung erzeugt, ist es bereits aus der EP-B 0 530 640 bekannt, entsprechende Strahlumlenker symmetrisch zu gestalten, so daß der Strahlumlenker zwei Symmetrieebenen aufweist, die senkrecht zur Bahnebene der Teilchenstrahlen stehen und gleichzeitig in den Winkelhalbierenden der in den einzelnen Bereichen des Umlenkers erzielten Umlenkungen liegen. Durch diese Symmetrie im Aufbau des Strahlumlenkers und die gleichzeitige Abbildung der Symmetrieebenen aufeinander durch einen Spiegel oder eine Kombination aus einem Spiegel und einer Feldlinse wird innerhalb des Strahlumlenkers ein zu den Symmetrieebenen symmetrischer Verlauf der Fundamentalbahnen des Teilchenstrahles erreicht, wodurch die Fehler zweiter Ordnung innerhalb des Strahlumlenkers verschwinden. Damit dieser symmetrische Verlauf der Fundamentalbahnen innerhalb des Umlenkers gewährleistet ist, ist es jedoch erforderlich, daß der elektrostatische Spiegel einerseits konjugiert zu den Symmetrieebenen des Umlenkers angeordnet ist und andererseits gleichzeitig die Symmetrieebenen im Abbildungsmaßstab 1:1 aufeinander abbildet.

Wird bei diesem Umlenker aus nur zwei quadratischen Sektormagneten eine Zwischenbildebene in die Symmetrieebenen abgebildet, so resultiert ein zwar einfacher und kurzer Aufbau, jedoch entstehen aufgrund der großen Dispersion im Spiegel Kombinationsfehler, die nur mit eingeschränkter Qualität korrigierbar sind. Wird hingegen die Beugungsebene der Objektivlinse in die Symmetrieebene des Umlenkers abgebildet, treten derartige Kombinationsfehler aufgrund einer verschwindenden Dispersion im Spiegel nicht auf. Allerdings tritt in diesem Betriebsmode eine Dispersion im Bild auf, die sich erst nach zweifachem Durchlauf durch den Umlenker herausheben muß. Die große Brennweite des Umlenkers erfordert dann jedoch eine Verkleinerung des Bündeldurchrnessers, die nur durch sehr große Längen oder mindestens zweistufige Objektivsysteme und ebenfalls mindestens zweistufige Spiegelsysteme realisierbar sind.

In der EP 0 530 640 sind weiterhin bereits Umlenker beschrieben, die für einen einfachen Durchgang des Teilchenstrahles dispersionsfrei sind. Diese weisen jedoch entweder drei verschiedene Magnetfelder mit einem zusätzlichen überlagerten elektrostatischen Feld oder Magnetsektoren mit teilweise konkaven Außenflächen auf. Konkave Außenflächen der Magnetsektoren erfordern jedoch eine entsprechend konkave Ausformung der Magnetspulen, wodurch auch wiederum herstellungs-technische Probleme insbesondere in einer Serienproduktion auftreten.

Ziel der vorliegenden Erfindung ist ein Teilchenstrahlsystem mit einem Spiegelkorrektor anzugeben, das einen insgesamt vereinfachten und kompakteren Aufbau ermöglicht.

Dieses Ziel wird durch ein Teilchenstrahlsystem mit den Merkmalen des Anspruches 1 gelöst. Vorteilhafte Ausgestaltungen der Erfindung ergeben sich aus den Merkmalen der abhängigen Ansprüche.

Wie das in der eingangs zitierten EP-B1 530640 beschriebene System weist auch das System nach der Erfindung einen Strahlumlenker auf, der für jeweils einen einfachen Durchgang dispersionsfrei ist. Unter dispersionsfrei ist dabei zu verstehen, daß die Dispersion des Umlenkers so gering ist, daß bei einer optimalen Justierung der Komponenten des Umlenkers eine verschwindende Dispersion erreichbar ist.

Zusätzlich zur Dispersionsfreiheit weist der Umlenker Quadrupole oder Quadrupolkomponenten auf, die so gewählt sind, daß auf dem gesamten Bahnverlauf zwischen dem erstmaligen Austritt aus dem Umlenker und dem Objektiv maximal zwei zur Beugungsebene des Objektivs konjugierte Ebenen und damit zwei Zwischenbildebenen der Beugungsebene des Objektivs auftreten.

Da der Umlenker hinreichend teleskopisch ist, verlaufen Teilchenstrahlen, die vom Schnittpunkt der Symmetrieebenen mit der optischen Achse ausgehen, außerhalb des Umlenkers parallel oder nur schwach konvergent.

Eine zur Beugungsebene des Objektivs konjugierte Ebene fällt vorzugsweise mit der Ebene des elektrostatischen Spiegel, also der Ebene, in der für alle Bahnen die Umkehrpunkte aufgrund des elektrostatischen Gegenfeldes liegen, zusammen. Dieser Zustand läßt sich durch eine zusätzliche Feldlinse einstellen.

Wie die bekannten Strahlumlenker weist auch der Strahlumlenker bei der Erfindung vorzugsweise in einem ersten Bereich eine erste Symmetrieebene und in einem zweiten Bereich eine zweite Symmetrieebene auf, so daß die Umlenkung jeweils symmetrisch zu diesen Symmetrieebenen erfolgt.

In jedem der zwei symmetrischen Bereiche weist der erfindungsgemäße Strahlumlenker jeweils mindestens zwei äußere Magnetsektoren und mindestens einen inneren Magnetsektor auf. Zwischen den äußeren und inneren Magnetsektoren sind weiterhin vorzugsweise Driftstrecken in magnetfeldfreien Zwischenräumen vorgesehen.

Da zwischen den Magnetsektoren Driftstrecken vorgesehen sind, können die Ein- und Austrittskanten gegenüber der optischen Achse abweichende Neigung aufweisen, wodurch eine Fokussierung parallel zur Richtung der Magnetfelder erfolgt. Diese Fokussierung durch die Quadrupolkomponenten an den Ein- und Austrittskanten stimmt dabei mit der Fokussierung senkrecht zur Magnetfeldrichtung, die durch die umlenkenden Magnetfelder erzeugt wird, überein, so daß der Umlenker insgesamt eine stigmatische Abbildung wie eine Rundlinse erzeugt. Alternativ oder zusätzlich zu den geneigten Ein- und Austrittskanten können jedoch auch Quadrupol-Elemente in dem Umlenker oder unmittelbar vor und hinter dem Umlenker vorgesehen sein.

Die Umlenkwinkel in den einzelnen Magnetsektoren sind so gewählt, daß jeweils nach einfachem Durchgang durch den Umlenker eine verschwindende Gesamtdispersion auftritt. Kombinationsfehler, die durch die Wechselwirkung der Dispersion mit dem Farb- oder Üffnungsfehler eines dem Umlenker nachgeschalteten elektrostatischen Spiegels auftreten, werden dadurch vermieden. Außerdem entsteht nicht in Zwischenbildern eine Dispersion, die in einem zweiten Durchgang durch den Umlenker extrem genau zu kompensieren wäre. Ein derartiger für einen einfachen Durchgang dispersionsfreier Strahlumlenker läßt sich erreichen, wenn das Magnetfeld im mittleren Magnetsektor antiparallel zur Magnetfeldrichtung in den äußeren Magnetsektoren ist.

Bei einem weiterhin vorteilhaften Ausführungsbeispiel sind die Magnetfelder im inneren und den beiden äußeren Magnetsektoren betragsmäßig gleich. Dadurch können Hauptspulen mit derselben Windungszahl für die Erzeugung der verschiedenen Magnetfelder in Serienschaltung zum Einsatz kommen, wodurch wiederum geringere Anforderungen an die Stabilität der Stromquellen resultieren.

Der Strahlumlenker ist weiterhin vorzugsweise rein magnetisch, d.h. weder zur Umlenkung des Teilchenstrahls noch zur Fokussierung senkrecht zu der Umlenkrichtung sind elektrostatische Felder vorgesehen.

Die Neigung der Ein- und Austrittskanten der äußeren Magnetsektoren zur optischen Achse und die Strahlumlenkung aufgrund der Magnetfelder in den Magnetsektoren wird vorteilhafter Weise so gewählt, daß parallel zur optischen Achse eintretende Teilchen in oder in unmittelbarer Nähe der Symmetrieebene des Umlenkers fokussiert werden. Dadurch wird erreicht, daß die Feldbahnen außerhalb des Umlenkers parallel oder nahezu parallel zur optischen Achse verlaufen und demzufolge die Schnittpunkte der Feldbahnen mit der optischen Achse weit beabstandet von den Ein- und Austrittskanten des Umlenkers liegen. Dadurch ist nur eine einzige zusätzliche Feldlinse zur Abbildung der Feldbahnen, jedoch keine zusätzliche Abbildung der axialen Bahnen, die eine weitere Zwischenabbildung erfordern würde, erforderlich.

Eine entsprechende Feldlinse ist vorzugsweise als elektrostatische Immersionslinse mit Mittelelektrode ausgebildet, so daß insgesamt eine Abbildung resultiert. Dadurch kann der Strahlumlenker auch bei variablem Säulenpotential bei einem festen Potential betrieben werden. Auch andere Formen von magnetischen und/oder elektrostatischen Linsen sind jedoch möglich.

Weiterhin ist es vorteilhaft, wenn zwischen dem Strahlumlenker und dem Objektiv ein oder zwei Oktupolelemente oder Elemente höherer Ordnung, insbesondere Zwölfpolelemente, mindestens mit Quadrupol-, Hexapol- und Oktupolwicklungen vorgesehen sind. Zusätzlich können der oder die Zwölfpolelemente auch noch Dipolwicklungen aufweisen; alternativ zu diesen Dipolwicklungen sind jedoch auch zwei oder drei separate Einzelablenksysteme möglich. Der oder die Zwölfpolelemente können dann als verbesserte, aufgeblasene Stigmatoren dienen und eine insgesamt stigmatische Abbildung sicherstellen. Der bzw. die Zwölfpolemente können dabei als Luftspulen ausgebildet sein. Denkbar ist es weiter, die beiden Zwölfpolelemente ohne weitere Ablenksysteme zwischen dem Umlenker und dem Objektiv anzuordnen. In diesem Fall sollten jedoch alle zwölf Pole beider Zwölfpolelemente jeweils separat und unabhängig voneinander ansteuerbar, d.h. mit Strom beaufschlagbar sein. Alternativ dazu ist es denkbar, sowohl zwischen dem Strahlumlenker und dem ersten dem Strahlumlenker nachfolgenden Zwölfpolelement, zwischen beiden Zwölfpolelementen und in Strahlrichtung gesehen hinter dem zweiten Zwölfpolelement jeweils Einzelablenksysteme vorzusehen. Die Einzelablenksysteme dienen dabei zur Strahljustierung.

Zwei elektrostatische Einzelablenker sollten zwischen dem Umlenker und dem elektrostatischen Spiegel angeordnet sein. Alternativ können die Multipolelemente in elektrisch-magnetischer Ausführung auch zwischen dem Umlenker und dem elektrostatischen Spiegel angeordnet werden, insbesondere wenn der zwischen dem Objektiv und dem Strahlumlenker vorhandene Bauraum unzureichend ist.

Weiterhin ist es vorteilhaft, einen Stigmator zwischen der Teilchenquelle und dem Umlenker vorzusehen, um durch Variation des Stigmators die Abbildungsverhältnisse, insbesondere Restverzeichung und Restastigmatismus, in dem Umlenkbereich des Umlenkers zwischen der Teilchenquelle und dem elektrostatischen Spiegel zu justieren.

Als vorteilhaft hat es sich herausgestellt, wenn die Teilchen zwischen dem Strahlumlenker und dem elektrostatischen Spiegel eine Mindestenergie aufweisen, die nicht unterschritten wird. Deshalb ist es insbesondere bei Anwendungen mit niedriger kinetischer Energie der Teilchen vorteilhaft, sowohl zwischen der Teilchenquelle und dem Umlenker und zwischen dem Umlenker und dem Objektiv jeweils eine elektrostatische Immersionslinse vorzusehen, durch die die kinetische Energie der Teilchen vor dem Eintritt in den Umlenker erhöht und nach Austritt aus dem Umlenker wieder reduziert wird. Dadurch kann der Umlenker bei konstanter kinetischer Energie der Elektronen im Bereich des Umlenkers und damit bei konstanten magnetischen Umlenkfeldern betrieben werden.

Die Gesamtumlenkung bei einfachem Durchgang durch den Umlenker beträgt vorzugsweise 90°, so daß nach zweifachem Durchgang durch den Umlenker mit zwischenliegender Reflexion der Teilchen die austretende optische Achse koaxial zur einfallenden optischen Achse verläuft.

Das Gesamtsystem mit Spiegelkorrektor wird vorzugsweise so betrieben, daß gleichzeitig der Farb- und der Öffnungsfehler des gesamten Abbildungssystems zwischen der Teilchenquelle und dem Objektiv korrigiert ist, wodurch insgesamt die Auflösung-eines entsprechenden Teilchenstrahlsystems erhöht werden kann.

Nachfolgend werden Einzelheiten der Erfindung anhand des in den Figuren dargestellten Ausführungsbeispiels näher erläutert. Im einzelnen zeigen:

Figur 1    eine Prinzipskizze eines Rasterelektronenmikroskops mit einem Spiegelkorrektor, nach der Erfindung;

Figur 2    eine vergrößerte Darstellung des Strahlumlenkers in Figur 1;

Figur 3    ein Diagramm der Verläufe der Fundamentalbahnen für 15keV Elektronen durch den Strahlumlenker in Figur 2.

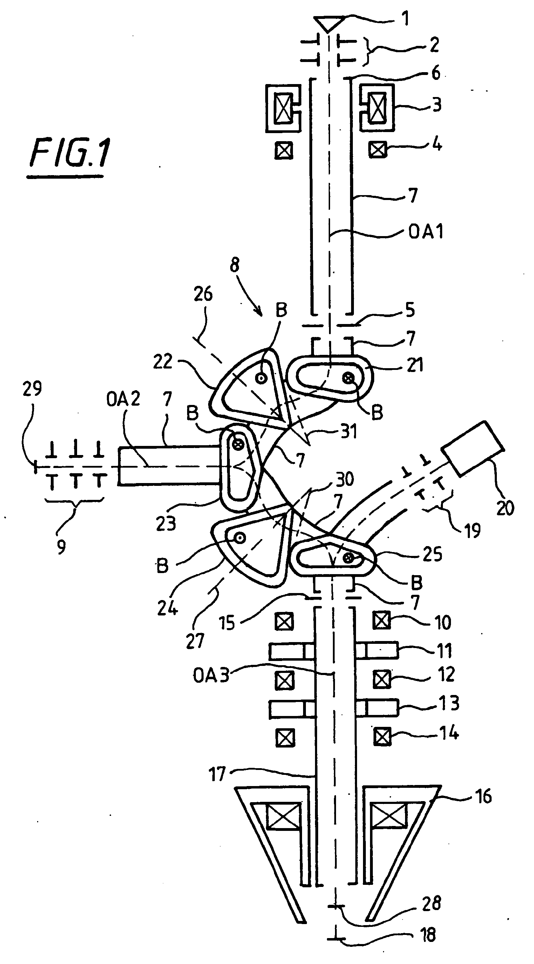

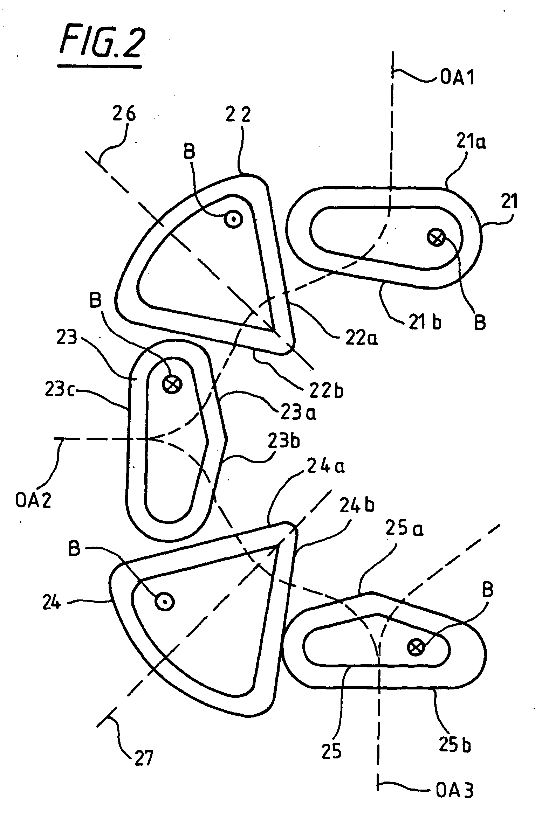

Das in der Figur 1 dargestellte Rasterelektronenmikroskop weist eine Teilchenquelle (1) mit einem der Teilchenquelle (1) nachfolgenden Strahlbeschleuniger (2) auf. Nach Durchlauf durch den Strahlbeschleuniger (2) werden die Teilchen auf das Potential des Strahlfiihrungsrohres (6) beschleunigt. Im Bereich des Strahlführungsrohres (6), das beispielsweise gegenüber der Teilchenquelle (1) auf einem Potential von 10kV liegt, ist eine magnetische Kondensorlinse (3) und ein der Kondensorlinse (3) nachfolgender Stigmator (4) vorgesehen. Die Kondensorlinse (3) dient dabei zur Bündelaufweitung im weiter unten nachfolgenden Strahlrohr. Auf den Stigmator (4) folgt eine erste elektrostatische Immersionslinse (5), durch die die Elektronen auf eine höhere kinetische Energie, die des inneren Strahlftihrungsrohres (7), nachbeschleunigt werden. Im Bereich des inneren Strahlführungsrohres (7) etwa in der Mitte des Rasterelektronenmikroskopes ist der Strahlumlenker mit den Magnetsektoren (21 - 25) angeordnet. Der Strahlumlenker wirkt dabei als teilchenoptischer Strahlteiler, der den entlang einer ersten optischen Achse (OA1) einfallenden Elektronenstrahl in Richtung einer gegenüber der einfallenden optischen Achse (OA1) abgelenkten optischen Achse (OA2) umlenkt. Gleichzeitig lenkt der Strahlumlenker ein in Richtung der umgelenkten optischen Achse (OA2) einfallenden Elektronenstrahl in Richtung einer austrittsseitigen optischen Achse (OA3) um, die koaxial zur einfallsseitigen optischen Achse (OA1) verläuft. Die Strahlumlenkung zwischen der einfallenden optischen Achse (OA1) und der umgelenkten optischen Achse (OA2) innerhalb des Strahlumlenkers erfolgt dabei symmetrisch zu einer ersten Symmetrieebene (26) und die Strahlumlenkung zwischen der umgelenkten optischen Achse (OA2) und der austrittsseitigen optischen Achse (OA3) symmetrisch zu einer zweiten Symmetrieebene (27). Die bei der Umlenkung von der einfallenden optischen Achse (OA1) zur umgelenkten optischen Achse (OA2) durchlaufenen drei Magnetsektoren (21, 22, 23) bilden demzufolge einen ersten Umlenkbereich, der symmetrisch zur ersten Symmetrieebene (26) ist und die bei der Umlenkung von der umgelenkten optischen Achse (OA2) zur austrittsseitigen optischen Achse (OA3) durchlaufenen drei Magnetsektoren (23, 24, 25) bilden einen zweiten Umlenkbereich, der symmetrisch zur zweiten Symmetrieebene (27) ist. Die Magnetfeldrichtung in den drei äußeren Umlenkbereichen (21, 23, 25) ist dabei aus Symmetriegründen identisch und parallel zueinander. In den beiden mittleren Magnetsektoren (22, 24) ist demgegenüber die Magnetfeldrichtung anti-parallel zur Magnetfeldrichtung in den drei äußeren Magnetsektoren (21, 23, 25), so daß die Strahlumlenkung aus Teilumlenkungen in alternierenden Richtungen zusammengesetzt ist. Weitere Einzelheiten im Zusammenhang mit dem Strahlumlenker werden nachfolgend noch anhand der Figur 2 beschrieben.

Im gegenüber der einfallenden optischen Achse (OA1) umgelenkten Arm folgt dem Strahlumlenker ein elektrostatischer Spiegel (9) nach. Die durch den Spiegel (9) zurückreflektierten Elektronen treten wieder in den Magnetsektor (23) ein, werden darin jedoch nun aufgrund der entgegengesetzten Bewegungsrichtung gegenüber dem ersten Durchlauf durch den Magnetsektor (23) in entgegengesetzter Richtung umgelenkt. Nachfolgend durchlaufen die zurückreflektierten Elektronen die beiden nachfolgenden Magnetsektoren (24, 25) und treten anschließend entlang der optischen Achse (3) koaxial zur einfallenden optischen Achse (OA1) wieder aus dem Strahlumlenker aus. Die bei einem einfachen Durchlauf durch den Strahlumlenker erzeugte Strahlumlenkung ist dabei auf 90° aufgelegt, so daß der Strahlumlenker insgesamt symmetrisch zur umgelenkten optischen Achse (OA2) ist. Da die Magnetsektoren neben ihren strahlumlenkenden Eigenschaften auch abbildende Eigenschaften haben, entstehen Bilder der Spiegelebene (29) in Ebenen (30, 31), die in der Nähe der Symmetrieebenen (26, 27) des Strahlumlenkers liegen. Bei idealer Justierung liegen die Bilder der Spiegelebene (29) exakt in den Symmetrieebenen (26, 27) des Umlenkers, geringfügige Abweichungen von dieser idealen Justierung wirken sich jedoch nicht sehr nachteilig aus.

Dem Strahlumlenker folgt in Bewegungsrichtung der Elektronen unmittelbar eine zweite elektrostatische Immersionslinse (15), durch die die Elektronen auf die Energie des Strahlführungsrohres (17) im Objektiv (16) abgebremst werden. Gleichzeitig bildet die Immersionslinse (15) die Bildebene (30) der Spiegelebene (29) in eine Ebene in der Nähe der Beugungsebene (28) der Objektivlinse ab. Darauf anschließend folgt in Strahlrichtung gesehen ein System aus zwei Zwölfpolelementen (11, 13) mit vor-, zwischen- und nachgeschalteten Einfach-Ablenksystemen (10, 12, 14) nach.

Aufgrund der kurzen Brennweite und der daraus resultierenden räumlichen Nähe zwischen der Hauptebene und der Beugungsebene des Objektivs (16) ist es relativ unkritisch, ob die Ebene, in die die Spiegelebene (29) abgebildet ist, mit der Beugungsebene (28) des Objektivs (16) exakt übereinstimmt. Insgesamt treten zwischen der Spiegelebene und dem Objektiv nur zwei Zwischenbilder der Beugungsebene (28) des Objektivs (16) auf, von denen eins in der Nähe des Zwischenbildes (30) der Spiegelebene (29) und das zweite in der Nähe der Spiegelebene (29) liegt.

Im Normalfall entspricht das Potential des Strahlführungsrohres im Objektiv (16) dem Potential des Strahlführungsrohres (6) im Bereich der Kondensorlinse (3). Durch das Objektiv (16) wird der einfallende Elektronenstrahl in die Brennebene (18) des Objektivs (16) fokussiert. Das Objektiv (16) kann dabei entweder als rein magnetische Objektivlinse oder als Kombination aus magnetischer Objektivlinse und elektrostatischer Immersionslinse ausgebildet sein. Im letzteren Fall wird die elektrostatische Immersionslinse dadurch gebildet, daß das Strahlführungsrohr (17) innerhalb der Objektivlinse (16) auf Höhe des Polschuhspaltes der Objektivlinse (16) oder dahinter endet und die Elektronen nach Austritt aus dem Strahlführungsrohr (17) auf das Potential der in der Nähe der Brennebene (18) der Objektivlinse (16) angeordneten Probe abgebremst werden.

Die durch Wechselwirkung mit der in der Nähe der Brennebene des Objektivs angeordneten Probe entstehenden zurückgestreuten oder Sekundärelektronen werden durch das höhere Potential des Strahlführungsrohres (17) wieder in das Strahlführungsrohr (17) hinein zurückbeschleunigt und durchlaufen den Strahlengang zwischen der Objektivlinse (16) und den Strahlumlenker in entgegengesetzter Richtung. Aufgrund der nun wiederum invertierten Bewegungsrichtung werden die zurückgestreuten Elektronen und Sekundärelektronen beim Eintritt in den Strahlumlenker im Magnetsektor (25) in entgegengesetzter Richtung umgelenkt, so daß sie von dem einfallenden Elektronenstrahl getrennt werden. Durch einen im umgelenkten Seitenarm dem Strahlumlenker nachfolgenden Detektor (20) können sowohl die Sekundärelektronen als auch die zurückgestreuten Elektronen detektiert werden. Durch eine dem Detektor (20) vorgeschaltete elektrostatische Linse (19) ist durch Anlegen unterschiedlicher Potentiale eine energetische Trennung zwischen zurückgestreuten Elektronen und Sekundärelektronen nach der Gegenfeldmethode möglich.

Der gesamte Strahlumlenker besteht insgesamt aus fünf Magnetsektoren (21 - 25). Alle fünf Magnetsektoren (21 - 25) weisen dabei rein konvexe Außenflächen auf, so daß die für die Erzeugung der Magnetfelder in den Magnetsektoren erforderlichen Spulen relativ einfach herstellbar sind. Die beiden inneren Magnetsektoren (22, 24) weisen dabei einen identischen Aufbau auf. Ebenfalls identisch aufgebaut sein können die insgesamt drei äußeren Magnetsektoren (21, 23, 25), wobei es jedoch für den ersten Magnetsektor (21) auch ausreicht, wenn dieser - wie in der Figur 2 dargestellt - lediglich einen zu einer Hälfte des dritten Magnetsektors (23) symmetrischen Aufbau aufweist. Ebenfalls braucht der letzte äußere Magnetsektor (25) nur in einer Hälfte einen zu einer Hälfte des Magnetsektors (23) symmetrischen Aufbau aufzuweisen und kann in der anderen Hälfte für das gegebenenfalls nachfolgende Detektionssystem optimiert sein. Die einzelnen Magnetsektoren sind so ausgebildet, daß die Eintrittskante (21a) des ersten Magnetsektors (21) senkrecht zur einfallenden optischen Achse (OA1), die Ein- bzw. Austrittskante (23c) des dritten Magnetsektors (23) senkrecht zur umgelenkten optischen Achse (OA2) und die Ein- bzw. Austrittskante (25b) des dritten Umlenkbereiches (25) senkrecht zur austretenden optischen Achse (OA3) ist. Die Neigung der Ein- bzw. Austrittskanten bestimmt dabei die Fokussierwirkung beim Ein- bzw. Austritt in die magnetischen Umlenkfelder (B) parallel oder anti-parallel zur Magnetfeldrichtung und damit senkrecht zur Zeichenebene in Figur 2.

Die Ein- und Austrittskanten (21 b, 22a, 22b, 23a, 23b, 24a, 24b und 25a) im Inneren des Umlenkers sind hingegen jeweils zur umgelenkten optischen Achse stark geneigt. Dadurch wird innerhalb des Strahlumlenkers eine Fokussierung parallel bzw. anti-parallel zur Magnetfeldrichtung in den Magnetsektoren erreicht, daß diese Fokussierung durch die Quadrupolkomponenten genauso groß wie die Fokussierung ist, die senkrecht zur Magnetfeldrichtung durch die Magnetfelder erzeugt wird, so daß der Strahlumlenker für einen einfachen Durchgang eine stigmatische Abbildung erzeugt, die der Abbildung einer Rundlinse entspricht.

Die Driftstreckenlängen zwischen den einzelnen Magnetsektoren und die Umlenkwinkel in den einzelnen Magnetsektoren, von denen aufgrund der Symmetriebedingungen ohnehin nur ein Wert als freier Parameter zur Verfügung steht, ergeben sich daraus, daß für den Strahlumlenker Dispersionsfreiheit für einen einfachen Durchgang gefordert wird und ein teleskopisch einfallendes Elektronenbündel den Umlenker möglichst schwach fokussiert verlassen soll.

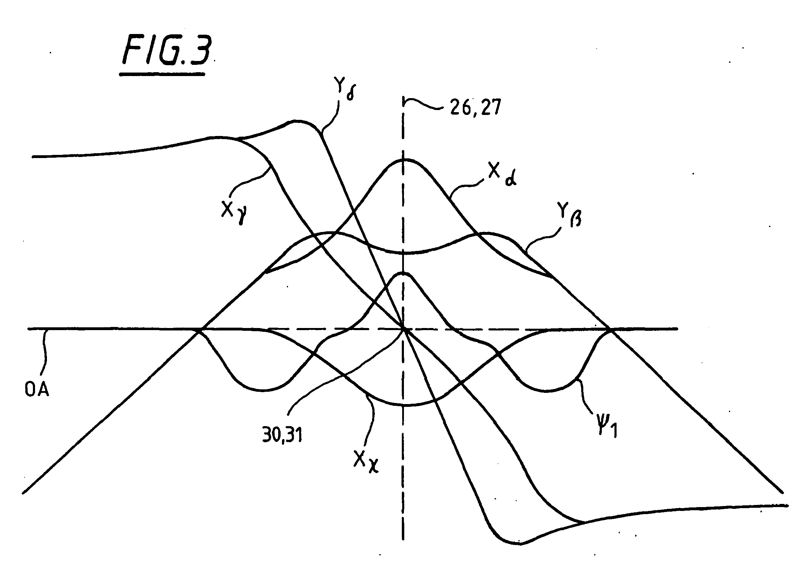

In der Figur 3 sind die Fundamentalbahnen für einen einfachen Durchgang durch den Strahlumlenker in Figur 2 für ein Elektron mit einer kinetischen Energie von 15keV dargestellt. Wie man erkennt, verlaufen sämtliche Fundamentalbahnen innerhalb des Umlenkers symmetrisch zu den Symmetrieebenen (26, 27). Die nahezu parallel zur optischen Achse (OA) einfallenden Feldbahnen $x_\gamma$, $y_\delta$ werden stigmatisch in der Symmetrieebene (26, 27) fokussiert. In der Symmetrieebene entsteht demzufolge ein stigmatisches Beugungsbild. Die Fokussierung der $x_\gamma$-Bahn erfolgt dabei durch die Dipolfelder in den Magnetsektoren, während die Fokussierung der $y_\delta$-Bahn durch die Quadrupolfelder erfolgt, die durch die Neigung der Ein- und Austrittskanten der Magnetsektoren im Inneren des Strahlumlenkers auftreten. Da gleichzeitig auch die Aperturbahnen $x_\alpha$, $y_\beta$ einen zu der Symmetrieebene (26, 27) symmetrischen Verlauf haben, wirkt der gesamte Strahlumlenker für einen einfachen Durchgang als magnetische Rundlinse. Wie weiterhin dem Verlauf der Dispersionsbahn $x_\kappa$ zu entnehmen ist, verschwindet bei dem Strahlumlenker die Dispersion bereits bei einem einfachen Durchgang, so daß der Strahlumlenker für einen einfachen Durchgang dispersionsfrei ist. Mit der Kurve $\psi 1$ ist in der Figur 3 der Verlauf der magnetischen Feldstärke entlang der optischen Achse dargestellt. Die Dispersionsfreiheit des Umlenkers für einen einzelnen Durchgang ergibt sich aus der Forderung, daß das Wegintegral des Produktes aus magnetischer Feldstärke ψ1 und sowohl xα als auch xγ zwischen Ein- und Austritt aus dem Umlenker verschwindet, also

$$\int \psi 1 \; x\alpha \; dz = 0 \quad \text{und} \qquad \int \psi 1 \; x\gamma \; dz = 0.$$

Bei dem in den Figuren dargestellten Ausführungsbeispiel sind nur zwei innere Magnetsektoren (22, 25) vorgesehen. Es ist jedoch auch möglich, diese inneren Magnetsektoren in mehrere Magnetsektoren aufzuspalten, so daß ein Umlenker mit 7 oder mehr Magnetsektoren und vergleichbaren Abbildungsleistungen entsteht. Es werden dann bei jedem einfachen Durchgang durch den Umlenker 4 oder entsprechend mehr Magnetsektoren durchlaufen.

**Patentansprüche**

1.  Teilchenstrahlsystem mit einer Teilchenquelle (1), einem Spiegelkorrektor (9, 21 - 25) und einem Objektiv (16), wobei der Spiegelkorrektor einen elektrostatischen Spiegel (9) und im Strahlengang zwischen der Teilchenquelle (1) und dem elektrostatischen Spiegel (9) sowie zwischen dem elektrostatischen Spiegel (9) und dem Objektiv (16) einen magnetischen Strahlumlenker (21, 22, 23, 24, 25) aufweist, **dadurch gekennzeichnet, dass** der magnetische Strahlumlenker (21, 22, 23, 24, 25) für jeweils einfachen Durchgang dispersionsfrei ist, und wobei der magnetische Strahlumlenker (21, 22, 23, 24, 25) Quadrupole und/oder Quadrupolkomponenten aufweist, die derart bestimmt sind, daß auf dem gesamten Bahnverlauf zwischen dem erstmaligen Austritt aus dem magnetischen Strahlumlenker (21, 22, 23) und dem Objektiv (16) maximal zwei zur Beugungsebene (28) des Objektivs (16) konjugierte Ebenen (29, 30) auftreten.

2.  Teilchenstrahlsystem nach Anspruch 1, wobei die Beugungsebene (28) des Objektivs (16) in die Spiegelebene (29) des elektrostatischen Spiegels (9) abgebildet ist.

3.  Teilchenstrahlsystem nach Anspruch 1 oder 2, wobei der Strahlumlenker mindesten drei äußere Magnetsektoren (21, 23, 25) und mindestens zwei innere Magnetsektoren (22, 24) aufweist, und wobei zwischen der Teilchenquelle (1) und dem Spiegel (9) zwei äußere Magnetsektoren (21, 23) mit einem dazwischen liegenden inneren Magnetsektor (22) sowie zwischen dem Spiegel (9) und dem Objektiv (16) zwei äußere Magnetsektoren (23, 25) mit einem dazwischen liegenden inneren Magnetsektor (24) durchlaufen werden.

4.  Teilchenstrahlsystem nach Anspruch 3, wobei das Magnetfeld in den inneren Magnetsektoren (22, 24) anti-parallel zur Magnetfeldrichtung in den äußeren Magnetsektoren (21, 23, 25) ist.

5.  Teilchenstrahlsystem nach einem der Ansprüche 1 - 4, wobei der Strahlumlenker rein magnetisch ist.

6.  Teilchenstrahlsystem nach einem der Ansprüche 1- 5, wobei der Strahlumlenker in einem ersten Bereich (21, 22, 23) eine Umlenkung symmetrisch zu einer ersten Symmetrieebene (26) und in einem zweiten Bereich (23, 24, 25) eine Umlenkung symmetrisch zu einer zweiten Symmetrieebene bewirkt.

7.  Teilchenstrahlsystem nach einem der Ansprüche 1 - 6, wobei der Umlenker zwischen den äußeren und inneren Magnetsektoren freie Driftstrecken im Magnetfeld freien Raum aufweist.

8.  Teilchenstrahlsystem nach einem der Ansprüche 1 - 7, wobei die zu den inneren Magnetsektoren (22, 24) zugewandten Ein- und Austrittskanten (21b, 23a, 23b, 25a) der äußeren Magnetsektoren (21, 23, 25) zur optischen Achse des Teilchenstrahls geneigt sind.

9.  Teilchenstrahlsystem nach einem der Ansprüche 1 - 8 wobei die Umlenkwinkel in den einzelnen Magnetsektoren (21, 22, 23, 24, 25) so gewählt sind, daß jeweils nach einfachem Durchgang durch den Strahlumlenker eine verschwindende Dispersion auftritt.

10.  Teilchenstrahlsystem nach einem der Ansprüche 1 - 9, wobei die Magnetfelder aller Magnetsektoren betragsmäßig gleich sind.

**11.** Teilchenstrahlsystem nach einem der Ansprüche 6 - 10, wobei annähernd parallel zur optischen Achse in den Umlenker eintretende Teilchen in der Symmetrieebene (26, 27) stigmatisch fokussiert werden.

**12.** Teilchenstrahlsystem nach einem der Ansprüche 1-11, wobei zwischen dem Strahlumlenker (21, 22, 23, 24, 25) und dem Objektiv (16) ein oder zwei magnetische oder elektrostatische Oktupole oder Multipolelemente höherer Ordnung (11, 13) angeordnet sind.

**13.** Teilchenstrahlsystem nach einem der Ansprüche 1 - 12, wobei zwischen der Teilchenquelle (1) und dem Umlenker (21 - 25) ein Stigmator (4) angeordnet ist.

**14.** Teilchenstrahlsystem nach einem der Ansprüche 1 - 13, wobei zwischen der Teilchenquelle (1) und dem Umlenker (21 - 25) und /oder zwischen dem Umlenker und dem Objektiv (16) eine Feldlinse (5, 15) vorgesehen ist.

**15.** Teilchenstrahlsystem nach Anspruch 14, wobei die Feldlinse zwischen der Teilchenquelle (1) und dem Umlenker (21 - 25) eine Immersionslinse (5) ist, durch die die kinetische Energie der Teilchen vor Eintritt in den Umlenker (21 - 25) erhöht wird.

**16.** Teilchenstrahlsystem nach einem der Ansprüche 14 oder 15, wobei die Feldlinse zwischen dem Umlenker (21 - 25) und dem Objektiv (16) eine Immersionslinse (15) ist, durch die die kinetische Energie der Teilchen nach Austritt aus dem Umlenker (21 - 25) reduziert wird.

**17.** Teilchenstrahlsystem nach einem der Ansprüche 1 - 16, wobei ein Teilchendetektor (20) vorgesehen ist, der auf der dem Objektiv (16) abgewandten Seite des dem Objektiv (16) am nächsten benachbarten Magnetsektors (25) und auf der dem elektrostatischen Spiegel (9) bezüglich der austrittsseitigen optischen Achse (OA3) gegenüber liegenden Seite angeordnet ist, und wobei der dem Objektiv (16) am nächsten benachbarte Magnetsektor (25) eine Trennung von aus einer Probe austretenden und vom Objektiv (16) aufgesammelten Teilchen von den Primärteilchen bewirkt

**Claims**

**1.** Particle beam system comprising a particle source (1), a mirror corrector (9, 21 - 25), and an objective lens (16), wherein the mirror corrector has an electrostatic mirror (9) and a magnetic beam deflector (21, 22, 23, 24, 25), which is arranged in the beam path between the particle source (1) and the electrostatic mirror (9) as well as between the electrostatic mirror (9) and the objective lens (16), **characterized in that** the magnetic beam deflector (21, 22, 23, 24, 25) is free from dispersion for in each case single passage, and wherein the magnetic beam deflector (21, 22, 23, 24, 25) has quadrupoles and/or quadrupole components, which are defined in such a manner that a maximum of two planes (29, 30), which are conjugated with regard to the diffraction plane (28) of the objective lens (16), occur on the entire path length between the first exit from the magnetic beam deflector (21, 22, 23) and from the objective lens (16).

**2.** Particle beam system according to Claim 1, wherein the diffraction plane (28) of the objective lens (16) is imaged into the mirror plane (29) of the electrostatic mirror (9).

**3.** Particle beam system according to either of Claims 1 and 2, wherein the beam deflector has at least three outer magnet sectors (21, 23, 25) and at least two inner magnet sectors (22, 24), and wherein between the particle source (1) and the mirror (9), two outer magnet sectors (21, 23) with one inner magnet sector (22), which lies between the two outer magnet sectors, and, between the mirror (9) and the objective lens (16), two outer magnet sectors (23, 25) with one inner magnet sector (24), which lies between the two outer magnet sectors, are passed through by particles.

**4.** Particle beam system according to Claim 3, wherein the magnetic field in the inner magnet sectors (22, 24) is anti-parallel to the magnetic field direction in the outer magnet sectors (21, 23, 25).

**5.** Particle beam system according to one of Claims 1-4, wherein the beam deflector is purely magnetic.

**6.** Particle beam system according to one of Claims 1-5, wherein the beam deflector effects a deflection in a first region (21, 22, 23) which is symmetrical to a first plane of symmetry (26) and effects a deflection in a second region (23, 24, 25) which is symmetrical to a second plane of symmetry.

7. Particle beam system according to one of Claims 1-6, wherein the deflector has free drift distances in the magnetic-field-free space between the outer and inner magnet sectors.

8. Particle beam system according to one of Claims 1-7, wherein the entry and exit edges (21b, 23a, 23b, 25a), which face the inner magnet sectors (22, 24), of the outer magnet sectors (21, 23, 25) are inclined towards the optical axis of the particle beam.

9. Particle beam system according to one of Claims 1-8, wherein the deflection angles in the individual magnet sectors (21, 22, 23, 24, 25) are chosen such that a vanishing dispersion occurs in each case after a single passage through the beam deflector.

10. Particle beam system according to one of Claims 1-9, wherein the magnetic fields of all magnet sectors are the same in terms of magnitude.

11. Particle beam system according to one of Claims 6-10, wherein particles which enter the deflector approximately parallel to the optical axis are stigmatically focussed in the plane of symmetry (26, 27).

12. Particle beam system according to one of Claims 1-11, wherein one or two magnetic or electrostatic high-order octupoles or multipole elements (11, 13) are arranged between the beam deflector (21, 22, 23, 24, 25) and the objective lens (16).

13. Particle beam system according to one of Claims 1-12, wherein a stigmator (4) is arranged between the particle source (1) and the deflector (21-25).

14. Particle beam system according to one of Claims 1-13, wherein a field lens (5, 15) is provided between the particle source (1) and the deflector (21-25) and/or between the deflector and the objective lens (16).

15. Particle beam system according to Claim 14, wherein the field lens between the particle source (1) and the deflector (21-25) is an immersion lens (5) by means of which the kinetic energy of the particles is increased before they enter the deflector (21-25).

16. Particle beam system according to either of Claims 14 or 15, wherein the field lens between the deflector (21-25) and the objective lens (16) is an immersion lens (15) by means of which the kinetic energy of the particles is reduced after the exit from the deflector (21-25).

17. Particle beam system according to one of Claims 1-16, wherein a particle detector (20) is provided which is arranged on the side, which faces away from the objective lens (16), of that magnet sector (25) which is the closest neighbour of the objective lens (16) and on the side which lies opposite the electrostatic mirror (9) with respect to the exit-side optical axis (OA3), and wherein the magnet sector (25), which is the closest neighbour of the objective lens (16), effects a separation of particles which exit a sample and are collected by the objective lens (16) from the primary particles.

**Revendications**

1. Système de faisceau de particules avec une source de particules (1), un correcteur spéculaire (9, 21 - 25) et un objectif (16), le correcteur spéculaire comportant un miroir électrostatique (9) et, dans le chemin du faisceau entre la source de particules (1) et le miroir électrostatique (9) ainsi qu'entre le miroir électrostatique (9) et l'objectif (16), un déviateur magnétique de faisceau (21, 22, 23, 24, 25), **caractérisé en ce que** le déviateur magnétique de faisceau (21, 22, 23, 24, 25) est sans dispersion pour chaque passage simple et que le déviateur magnétique de faisceau (21, 22, 23, 24, 25) comporte un quadrupôle et/ou des composants quadrupôlaires qui sont définis de telle sorte que n'apparaissent au maximum que deux plans (29, 30) conjugués du plan de diffraction (28) de l'objectif (16) sur l'ensemble de la trajectoire entre la première sortie du déviateur magnétique de faisceau (21, 22, 23) et l'objectif (16).

2. Système de faisceau de particules selon la revendication 1, dans lequel le plan de diffraction (28) de l'objectif (16) est reproduit dans le plan du miroir (29) du miroir électrostatique (9).

3. Système de faisceau de particules selon la revendication 1 ou 2, dans lequel le déviateur de faisceau présente au moins trois secteurs magnétiques externes (21, 23, 25) et au moins deux secteurs magnétiques internes (22, 24), et dans lequel entre la source de particules (1) et le miroir (9), on traverse deux secteurs magnétiques externes (21, 23) avec un secteur magnétique interne (22) intercalé entre eux, de même qu'entre le miroir (9) et l'objectif (16), on traverse deux secteurs magnétiques externes (23, 25) avec un secteur magnétique interne (24) intercalé entre eux.

4. Système de faisceau de particules selon la revendication 3, dans lequel le champ magnétique dans les secteurs magnétiques internes (22, 24) est antiparallèle à la direction du champ magnétique dans les secteurs magnétiques externes (21, 23, 25).

5. Système de faisceau de particules selon une des revendications 1 - 4, dans lequel le déviateur de faisceau est purement magnétique.

6. Système de faisceau de particules selon une des revendications 1 - 5, dans lequel le déviateur de faisceau produit une déviation symétrique par rapport à un premier plan de symétrie (26) dans une première zone (21, 22, 23) et une déviation symétrique par rapport à un deuxième plan de symétrie dans une deuxième zone (23, 24, 25).

7. Système de faisceau de particules selon une des revendications 1 - 6, dans lequel le déviateur présente des parcours de dérive libres dans l'espace libre du champ magnétique entre les secteurs magnétiques externes et internes.

8. Système de faisceau de particules selon une des revendications 1 - 7, dans lequel les bords d'entrée et de sortie (21b, 23a, 23b, 25a) des secteurs magnétiques externes (21, 23, 25), orientés vers les secteurs magnétiques internes (22, 24), sont inclinés vers l'axe optique du faisceau de particules.

9. Système de faisceau de particules selon une des revendications 1 - 8, dans lequel les angles de déviation dans les secteurs magnétiques individuels (21, 22, 23, 24, 25) sont choisis de telle sorte qu'il se produit une dispersion qui disparaît après chaque passage simple à travers le déviateur de faisceau.

10. Système de faisceau de particules selon une des revendications 1 - 9, dans lequel les champs magnétiques de tous les secteurs magnétiques sont de valeurs identiques.

11. Système de faisceau de particules selon une des revendications 6 - 10, dans lequel les particules pénétrant dans le déviateur de manière approximativement parallèle à l'axe optique sont focalisées de manière stigmatique dans le plan de symétrie (26, 27).

12. Système de faisceau de particules selon une des revendications 1 - 11, dans lequel un ou deux octupôles magnétiques ou électrostatiques ou éléments multipolaires d'ordre plus élevé (11, 13) sont disposés entre le déviateur de faisceau (21, 22, 23, 24, 25) et l'objectif (16).

13. Système de faisceau de particules selon une des revendications 1 - 12, dans lequel un correcteur d'astigmatisme (4) est disposé entre la source de particules (1) et le déviateur (21 - 25).

14. Système de faisceau de particules selon une des revendications 1 - 13, dans lequel une lentille de champ (5, 15) est prévue entre la source de particules (1) et le déviateur (21 - 25) et/ou entre le déviateur et l'objectif (16).

15. Système de faisceau de particules selon la revendication 14, dans lequel la lentille de champ entre la source de particules (1) et le déviateur (21 - 25) est une lentille à immersion (5) qui augmente l'énergie cinétique des particules avant de pénétrer dans le déviateur (21 - 25).

16. Système de faisceau de particules selon une des revendications 14 ou 15, dans lequel la lentille de champ entre le déviateur (21 - 25) et l'objectif (16) est une lentille à immersion (5) qui réduit l'énergie cinétique des particules après la sortie du déviateur (21 - 25).

17. Système de faisceau de particules selon une des revendications 1 à 16, dans lequel on a prévu un détecteur de particules (20), disposé sur le côté s'éloignant de l'objectif (16) du secteur magnétique (25) voisin le plus proche de l'objectif (16), et sur le côté opposé du miroir électrostatique (9) par rapport à l'axe optique (OA3) du côté de la sortie, et dans lequel le secteur magnétique (25) voisin le plus proche de l'objectif (16) produit une séparation des particules sortant d'un échantillon et collectées par l'objectif (16) par rapport aux particules primaires.

# FIG.1

FIG.2

## FIG.3

EP 1 362 361 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0530640 B1
- EP 0530640 B
- EP 0530640 A
- EP 530640 B1